# EUROPÄISCHE PATENTANMELDUNG

(11) **EP 1 450 279 A2**
(43) Veröffentlichungstag der Anmeldung: **25.08.2004**
(21) Anmeldenummer: 04100038.1
(22) Anmeldetag: 08.01.2004
(51) Int. Cl.: G06F 17/50

(54) **Verfahren zur Projektierung eines elektrischen Systems**

(30) Priorität: 11.02.2003 DE 10305637
(71) Anmelder: SIEMENS AKTIENGESELLSCHAFT, 80333 München (DE)
(72) Erfinder: Mikk, Erich, 91056, Erlangen (DE)

(57) **Zusammenfassung**

Die Erfindung besteht im Wesentlichen darin, dass unterschiedliche Mengen von Repräsentationen von Bausteinen eines zu projektierenden Systems, beispielsweise Bausteine in einem Continuous Function Chart (CFC) und Objekte in dem Visualisierungstool WinCC, auf eine gemeinsame Datenbasis zurückgreifen und die Information über die korrespondierenden Mengen von Repräsentationen in zwei beispielsweise HTML-Dokumente konvertiert werden, die Verweise jeweils zur anderen Menge von Repräsentationen aufweisen und dadurch ein Navigieren von einer Repräsentation zur anderen sowie eine konsistente Änderung in gleichzeitig mehreren Repräsentationen ermöglicht wird.

## Beschreibung

Die Erfindung betrifft Verfahren zur Projektierung eines elektrischen Systems, insbesondere die Projektierung von Gebäude- und Anlageninstallationen oder die Projektierung eines European Installation Bus (EIB), bei denen Systeme gleichzeitig in verschiedenen Repräsentationen, beispielsweise in einem Continuous Function Chart (CFC) und in einer Bedien- und Beobachtungsoberfläche wie WinCC® , projektiert werden. Continuous Function Charts oder CFCs werden häufig zur Planung von Automatisierungsaufgaben, beispielsweise zur Planung von Simatic-Steuerungen verwandt; ein solcher Hinweis findet sich beispielsweise auf der Internetseite http://www.ad.siemens.de/news/html 76/simrepo/4 96/html 76/pr od1 1.htm.

Gleichzeitig werden häufig auch die Bedien- und Beobachtungsoberflächen für eine Automatisierungsaufgabe, beispielsweise die Planung einer Simatic-Steuerung, gleichzeitig oder schritthaltend mit der Erstellung des CFC projektiert bzw. geändert. Auf der Internetseite http://www.ad.siemens.de/hmi/html 00/products/software/wincc/ index.htm ist beispielsweise eine solche Visualisierungsmöglichkeit für eine Simatic-Steuerung mit Hilfe des Programms WinCC® gezeigt.

Zur Navigation in den Engineering Daten muss sich ein Projektant üblicherweise in die Navigationsfunktionen jeder einzelnen Applikation individuell einarbeiten. Wird beispielsweise nach verlinkten Daten in mehreren Engineering-Tools gesucht, muss der Projektant in allen beteiligten Tools simultan navigieren. Eine Quernavigation entlang der zwischen den Tools verknüpften Daten erfordert einen beachtlichen Bedienungsaufwand und die Kenntnis der jeweiligen Ablageschemata bzw. ein Auffinden und Ablegen von Engineering-Daten erfordert die Kenntnis der branchen- oder projektspezifischen Konventionen. Die Anwendung der Konventionen ist mit einem gewissen Einarbeitungsaufwand verbunden und erfordert eine gewisse Sorgfalt und ist daher zeitintensiv. Die Daten werden bislang applikationsspezifisch abgelegt und sind nur durch die interaktive Bedienung in der Applikation selbst auffindbar. Die aktuellen Engineering-Daten sind nicht mit einer Dokumentation der zu projektierenden Anlage verknüpft, was einen erhöhten Pflegeaufwand der Dokumentation nach einer Änderung der Engineering-Daten zur Folge hat. Gegenwärtige Engineering-Tools unterstützen den Projektant beim Ablegen der Engineering-Daten nach Konventionen unter der Einschränkung, dass die Daten hierarchisch abgelegt sein müssen. Dies verhindert eine Querverknüpfung der Daten in den Ablageschemata bzw. eine applikationsübergreifende Datenablage. Die Engineering-Daten in der Anlagendokumentation sind in der Regel nur eine Kopie der aktuellen Daten, was zur Folge hat, dass nach jeder Änderung der aktuellen Daten die Dokumentation umständlich manuell erneuert werden muss.

Aus dem Siemens ITlusion White Paper mit dem Titel "Informationstechnologie in der Automatisierungstechnik, April 1999, Seite 20, ist beispielsweise bereits bekannt, dass für eine durchgängige Navigation zu allen Informationen ein entsprechender Aufbau als Website mit über Hyperlinkverbindungen vernetzten einzelnen Seiten erforderlich ist, wobei die hierarchische Komponentenstruktur der Anlage eine Struktur für die Website vorgibt. Ferner ist aus diesem Dokument, das unter der Internetadresse http://lhc-div.web.cern.ch/lhc-div/IndCtrl/GUAPI/CD-SimaticNet/Info/WP/WP ITlution 76.pdf verfügbar ist, bekannt, dass eine größere Flexibilität und leichtere Änderbarkeit durch eine strikte Trennung von Struktur und Nutzdaten erreichbar ist.

Die der Erfindung zugrundeliegende Aufgabe besteht nun darin, Verfahren zur Projektierung eines elektrischen Systems anzugeben, bei denen die oben genannten Nachteile vermieden werden und eine möglichst schnelle sowie eine konsistente Projektierung ermöglicht wird.

Diese Aufgabe wird durch die Merkmale der Ansprüche 1 und 4 in erfinderischer Weise gelöst. Die weiteren Ansprüche betreffen lediglich vorteilhafte Ausgestaltungen dieser Verfahren.

Die Erfindung besteht im Wesentlichen darin, dass unterschiedliche Mengen von Repräsentationen von Bausteinen eines zu projektierenden Systems, beispielsweise Bausteine in einem Continuous Function Chart (CFC) und Objekte in dem Visualisierungstool WinCC, auf eine gemeinsame Datenbasis zurückgreifen und die Information über die korrespondierenden Mengen von Repräsentationen der Bausteine des Systems beispielsweise in zwei HTML-Dokumente konvertiert werden, die Verweise jeweils zur anderen Menge von Repräsentationen aufweisen und dadurch ein Navigieren von einer Repräsentation zur anderen sowie eine konsistente Änderung in gleichzeitig mehreren Repräsentationen ermöglicht wird.

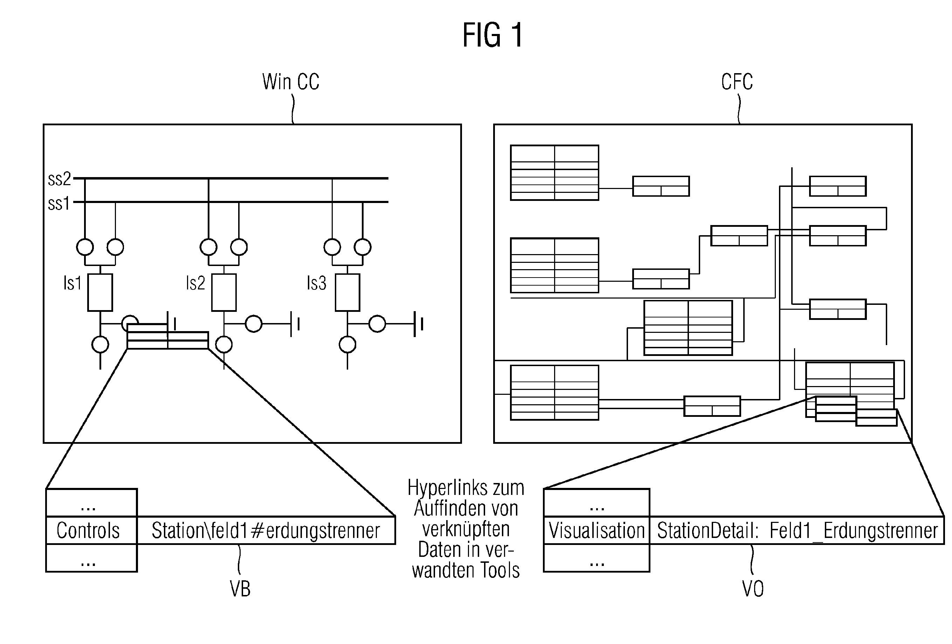

In Figur 1 sind die zu projektierenden Bausteine eines elektrischen Systems in Form einer ersten Menge CFC und einer korrespondierenden zweiten Menge von Repräsentationen WinCC ausschnittsweise dargestellt. Die erste Menge von Repräsentationen kann beispielsweise in einem Continuous Function Chart bzw. CFC und die zweite Menge von Repräsentationen beispielsweise für Bedien- und Beobachtungsoberfläche WinCC® bestehen. Die Darstellung der ersten Menge von Repräsentationen, also beispielsweise das CFC, enthält Elemente mit Verweisen VO auf die Objekte eines verwandten Werkzeugs, wie beispielsweise WinCC, wobei ein solcher Verweis VO beispielsweise folgende Bestandteile umfasst:
- **Visualization:** (Kennzeichnung des verwandten Tools bzw. der anderen Menge von Repräsentationen)
- **StationDetail:** (der Ort in dem verwandten Werkzeug, hier also in dem Visualisierungstool WinCC)
- **Feld1_Erdungstrenner:** (die konkrete Angabe für StationDetail)

In entsprechender Weise ist in der zweiten Menge von Repräsentationen, also beispielsweise in dem Visualisierungstool WinCC, an einer bestimmten Stelle, also beispielsweise beim Erdungstrenner von Feld1 ein Verweis VB vorhanden, der folgende Gestalt aufweist:
- **Controls** (der Verweis auf das betreffende verwandte Werkzeug, also beispielsweise das Continuous Function Chart)
- **Station\** (eine Angabe in welcher Station des CFC sich der Baustein befindet)
- **Feld1#Erdungstrenner** (eine Angabe um welchen Baustein es sich hierbei handelt)

Beiden Verweisen VB und VO ist jeweils beispielhaft nur ein verwandtes Werkzeug, also beispielsweise **Controls** oder **Visualization,** konkret angegeben; durch die Angabe "..." ist jedoch angedeutet, dass im Prinzip beliebig viele verwandte Werkzeuge bzw. Mengen von Repräsentationen auf diese Weise in eindeutiger Weise verbunden bzw. verknüpft werden können.

Bei der Projektierung eines elektrischen Systems werden zunächst beispielsweise Bausteine in dem Werkzeug CFC und Objekte in dem Werkzeug WinCC projektiert, wobei eine Korrespondenz zwischen den projektierten Bausteinen und den Objekten bzw. Symbolen existiert, die vom Projektanten im Rahmen der Projektierung etabliert wird. Der Projektant führt danach in einem ersten Schritt einen sogenannten "Mapper" bzw. eine Abbildung aus, der bzw. die in WinCC Kommunikationsvariablen anlegt, die mit projektierten Bausteinen assoziiert sind. Danach ordnet der Projektant üblicherweise in einem zweiten Schritt eine oder mehrere Kommunikationsvariablen in WinCC dem projektierten Objekten von WinCC zu, wodurch die Korrespondenz zwischen den projektierten Bausteinen und den WinCC-Objekten projektiert wird. Erfindungsgemäß wird nun in einem dritten Schritt mit Hilfe einer Datenbank und den dazugehörigen Funktionen die Information über die korrespondierenden Bausteine und WinCC-Objekte in jeweils zwei Dokumente einer Seitenbeschreibungssprache, beispielsweise HTML oder XML, konvertiert, wobei mit einem Baustein beispielsweise ein HTML-Dokument assoziiert wird, das die Verweise auf die korrespondierenden WinCC-Objekte enthält und wobei mit einem WinCC-Objekt beispielsweise ein HTML-Dokument assoziiert wird, das die Verweise an die korrespondierenden Bausteine im CFC enthält.

Durch Anklicken bzw. Auswahl des jeweiligen Verweises auf eine bestimmte Position in einem verwandten Werkzeug, kann der Projektant zwischen verwandten Werkzeugen, z. B. CFC und WinCC, hin- und herwechseln bzw. in beiden Werkzeugen navigieren. Für den Fall, dass die Kommunikationsstruktur zwischen den Bausteinen von CFC und den Objekten von WinCC durch den Projektanten geändert wird, braucht nur eine zentrale Datenbank aktualisiert werden, wodurch der Projektant jederzeit Zugriff auf die aktuellen Verweisstrukturen zwischen den korrespondierenden Objekten bzw. Bausteinen hat.

Eine weitere Ausbildung des erfinderischen Verfahrens besteht darin, nicht nur ein Navigieren zwischen zwei verwandten Werkzeugen, sondern auch innerhalb von Werkzeugen zu ermöglichen, die normalerweise eine solche Funktion nicht bereitstellen, was beispielsweise bei der Projektierung von Bausteinen und Verschaltungen im CFC der Fall ist. Um ein Navigieren im Continuous Flow Chart selbst zu ermöglichen, wird ein Graph, quasi als Navigationssicht erzeugt, der die Struktur des Projekts bzw. seiner Bausteine und Verschaltungen wiedergibt.

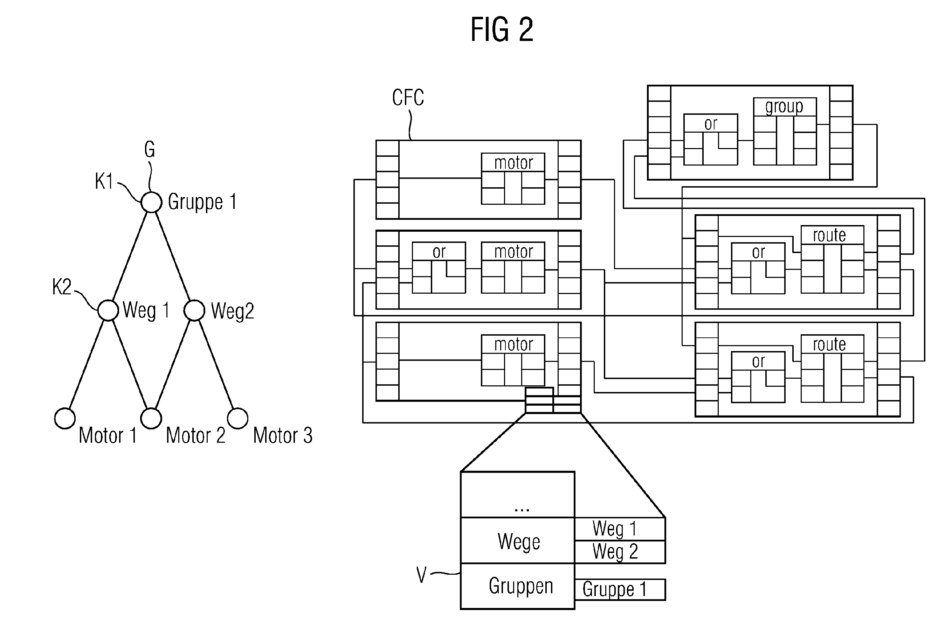

In Figur 2 ist ein solcher Graph G beispielhaft für eine Gruppe 1 dargestellt, die einen Weg 1 und einen Weg 2 beinhaltet, wobei der Weg 1 mit einem Motor 1 und einem Motor 2 und der Weg 2 ebenfalls mit dem Motor 2 und einem Motor 3 verbunden ist. Im ebenfalls in Figur 2 enthaltenen zugehörigen Ausschnitt des CFC ist außerdem beim Baustein Motor 2 beispielhaft ein Verweis V mit folgenden Angaben aus dem Graphen G gezeigt, wie er bspw. durch Anklicken des Symbols für den Motor 2 erzeugt wird:
**Gruppen:** Gruppe 1
**Wege:** Weg 1, Weg 2

Durch die Angabe "..." wird angedeutet, dass allgemein nicht nur zwei Hierarchieebenen möglich sind.

Zur Durchführung dieses Verfahrens wird zunächst vom Projektanten eine Menge von Bausteintypen als Knotenmenge des Graphen und für jeden Bausteintyp aus der Knotenmenge eine Menge von Verschaltungsinterfaces bestimmt. Ferner wird vom Projektant eine Menge von Verbindungsbausteinen festgelegt, die nicht in der Knotenmenge enthalten sind. Der Graph wird nun aus einer Menge von CFC-Plänen dadurch berechnet, dass jeder Baustein aus der Menge der CFC-Pläne genau dann ein Knoten des Graphen ist, wenn sein Bausteintyp in der Knotenmenge liegt und dass die Menge der Kanten des Graphen die maximale Menge der Kanten zwischen den benachbarten Knoten K1 und K2 des Graphen ist, wobei die Kanten nach folgender Vorschrift gebildet werden:

Es existieren Verschaltungen zwischen den assoziierten Bausteinen der Nachbarknoten K1 und K2, oder eine Kette von Verschaltungen, die in K1 beginnt und in K2 endet, so dass die verbundenen Bausteine in der Kette aus der Menge der Verbindungsbausteine sind, so dass die Verschaltung Interfaces verbindet, die in den jeweiligen Verschaltungsinterfaces liegen.

Wird bei der Projektierung der Bausteine und Verschaltungen im CFC die Verschaltungsinformation geändert, so wird nach obigem Verfahren jeweils ein neuer Graph erzeugt und angezeigt, wobei mit den Knoten Verweise auf die Bausteine angegeben bzw. assoziiert sind. Der Projektant kann nun durch Anklicken bzw. Auswahl dieser Verweise in den CFC-Plänen navigieren.

Durch eine applikationsübergreifende Datenablage der Engineering-Daten wird eine deutliche Reduktion des Navigationsaufwandes und eine Reduktion der Arbeitsschritte bei der Pflege der Anlagendokumentation möglich. Durch die erfindungsgemäßen Verfahren können beliebige, also nicht nur hierarchische Bezugsstrukturen, erzeugt werden. Eine Vielzahl der Verbindungen bzw. Hyperlinks kann hiermit auf der Basis der tatsächlich vorhandenen Verbindungen zwischen den Bausteinen automatisch erzeugt bzw. berechnet werden. Die automatisch erzeugten bzw. berechneten Hyperlinks können mit den tatsächlichen Verknüpfungen verglichen werden und die Projektierung bzw. deren Fortschritt überprüft werden.

## Patentansprüche

1. Verfahren zur Projektierung eines elektrischen Systems,
- bei dem projektierte Bausteine des Systems in Form einer ersten Menge von Repräsentation (CFC) und dazu korrespondierende projektierte Objekte einer zweiten Menge von Repräsentation (WinCC) der Bausteine erzeugt und dargestellt werden,
- bei dem, in einem ersten Schritt, Kommunikationsvariable in der zweiten Repräsentation angelegt und mit den Bausteinen assoziiert werden,
- bei dem, in einem zweiten Schritt, mindestens eine der Kommunikationsvariablen mindestens einem der projektierten Objekte zugeordnet wird und
- bei dem, in einem dritten Schritt, eine im ersten und zweiten Schritt gebildete Information über die korrespondierenden Bausteine und Objekten derart konvertiert wird,
- dass mit einem Baustein ein in einer Seitenbeschreibungssprache formuliertes Dokument assoziiert und dargestellt wird, das Verweise (VO) zu den korrespondierenden Objekten enthält und
- dass mit einem Objekt ein in einer Seitenbeschreibungssprache formuliertes weiteres Dokument assoziiert und dargestellt wird, das Verweise (VB) zu den korrespondierenden Bausteinen enthält.

2. Verfahren nach Anspruch 1,
- bei dem ein Navigieren zwischen der ersten und zweiten Menge von Repräsentationen der Bausteine mit Hilfe dieser Verweise erfolgt.

3. Verfahren nach Anspruch 1 oder 2,
- bei dem die Verweise geändert werden, sofern sich die Information über die korrespondierenden Bausteine und Objekte ändert.

4. Verfahren zur Projektierung eines elektrischen Systems,
- bei dem aus Mengen von Repräsentationen (CFC) von Knoten- und Verbindungs-Bausteinen des Systems ein Graph (G) derart erzeugt und angezeigt wird, dass der Graph nur für die Knoten-Bausteine (Gruppe 1, Weg1, Weg2, Motor1,..,Motor3) Knoten aufweist und dass die Repräsentationen (CFC) Verweise (V) auf die Knoten des Graphen aufweisen.

5. Verfahren nach Anspruch 4,
- bei dem ein Navigieren in der Repräsentation (CFC) der Bausteine des zu projektierenden Systems durch Auswahl dieser Verweise erfolgt.

6. Verfahren nach Anspruch 4 oder 5,
- bei dem ein neuer Graph bestimmt wird, sofern sich eine Information über die Verschaltung der Knoten-Bausteine ändert.

7. Verfahren nach einem der Ansprüche 4 bis 6,
- bei dem diese Verweise (V) mit den tatsächlich bestehenden Verbindungen in Relation gesetzt werden und hieraus ein Maß für den Projektierungsfortschritt abgeleitet wird.
